# EUROPEAN PATENT APPLICATION

(11) **EP 4 641 226 A1**
(43) Date of publication of application: **29.10.2025**
(21) Application number: 25159928.8
(22) Date of filing: 25.02.2025
(51) Int. Cl.: G01R 31/327

(54) **SYSTEM AND METHOD FOR DETECTING STICKING OF RELAY, ELECTRONIC APPARATUS, AND MEDIUM**

(30) Priority: 22.04.2024 CN 202410488735
(71) Applicant: Sungrow Charging Technology Co., Ltd., Hefei, Anhui 230088 (CN)
(72) Inventor: WANG, Shudong, Hefei, Anhui, 230088 (CN)
(74) Representative: Zacco Norway AS

(57) **Abstract**

A system and a method for detecting sticking of a relay, an electronic apparatus, and a medium are provided. In the system, a preset auxiliary detection circuit is provided between a neutral wire circuit and a live wire circuit of a charging station, and a resistance of a preset auxiliary resistor is greater than or equal to a preset threshold, so that a short circuit connection can be formed between the neutral wire circuit and the live wire circuit. In combination with the preset auxiliary resistor in the detection circuit, the accuracy of a current between the neutral wire circuit and the live wire circuit in the charging station is improved. In a case that relay sticking detection is performed based on a voltage between the neutral wire circuit and a ground wire circuit, the relay sticking detection of the neutral wire circuit can be performed based on a calculated sticking detection value with high accuracy. Since the charging station is in different circuit conduction conditions under different charging states, the relay sticking detection of the neutral wire circuit is performed based on an actual charging state of the charging station and the sticking detection value. The accuracy of the relay sticking detection of the neutral wire circuit is improved.

## Description

### FIELD

The present application relates to the technical field of circuit control, and in particular to a system and a method for detecting sticking of a relay, an electronic apparatus, and a medium.

### BACKGROUND

With the rapid popularization of electric automobiles, charging stations for the electric automobiles are rapidly constructed. A relay is a core component of a control circuit of a charging station, and a working state of the relay directly affects the safety of the charging station. During the operation of the charging station, the charging station is unable to be disconnected from a power supply grid or a power supply if a relay in the charging station is stuck, resulting in safety hazards such as overload, excessive current, or short circuit of the charging station.

### SUMMARY

Based on the above, to solve the problem of low accuracy of relay sticking detection for a neutral wire circuit in a charging station in the conventional technology, a system and a method for detecting sticking of a relay, an electronic apparatus, and a medium are provided according to the present application.

The technical solutions according to the embodiments of the present application are as follows.

In a first aspect, a system for detecting sticking of a relay, applied to a charging station, is provided according to the present application. The system includes a live wire circuit, a neutral wire circuit, a ground wire circuit, a detection voltage acquisition module and a first sticking detection module. The neutral wire circuit is in short circuit connection with the live wire circuit through a preset auxiliary detection circuit. The preset auxiliary detection circuit includes a preset auxiliary resistor, and a resistance of the preset auxiliary resistor is greater than or equal to a preset threshold. The detection voltage acquisition module is configured to acquire a sticking detection value based on the preset auxiliary detection circuit. The first sticking detection module is configured to perform relay sticking detection on a neutral-wire relay based on a charging state of the charging station and the sticking detection value.

In an embodiment, the first sticking detection module is specifically configured to:
determine a first preset detection value interval based on the charging state of the charging station; and
determine that the neutral wire circuit has a relay sticking fault in a case that the sticking detection value falls within the first preset detection value interval.

In an embodiment, the preset auxiliary detection circuit includes a preset auxiliary switch, and the live wire circuit includes a live-wire relay. The preset auxiliary switch has an end connected to an input terminal of the live-wire relay and the other end connected to an end of the preset auxiliary resistor, and the other end of the preset auxiliary resistor is connected to the neutral wire circuit. The preset auxiliary switch is in a closed state when the first sticking detection module performs sticking detection on the neutral-wire relay.

In an embodiment, the system further includes a circuit adjustment module, and the circuit adjustment module is specifically configured to:
connect a live wire connection terminal of the preset auxiliary detection circuit to an output terminal of the live-wire relay, in response to a live-wire-relay detection instruction; where the live-wire-relay detection instruction is for determining whether an abnormality occurs on the live-wire relay, and the live wire connection terminal of the preset auxiliary detection circuit is configured to indicate a connecting end point, on the live wire circuit, of the preset auxiliary detection circuit; and
determine that the live-wire relay has no abnormality in a case that the preset auxiliary detection circuit forms a short circuit connection between the neutral wire circuit and the live wire circuit.

In an embodiment, the system further includes a voltage fluctuation adjustment module and a power supply grid; the power supply grid is connected to the charging station; and the voltage fluctuation adjustment module is specifically configured to:
determine a voltage fluctuation coefficient of the power supply grid within a preset time interval based on voltage statistical data of the power supply grid within the preset time interval; and
adjust the first preset detection value interval based on the voltage fluctuation coefficient to obtain a second preset detection value interval.

In an embodiment, the system further includes a second sticking detection module, and the second sticking detection module is specifically configured to:
perform relay sticking detection on the live wire circuit to obtain a sticking detection result of the live-wire relay; and
control the preset auxiliary switch to be in an open state, in a case that the sticking detection result of the live-wire relay indicates that the live-wire relay is stuck.

In an embodiment, the charging station includes a three-phase charging station, and the three-phase charging station includes a three-phase live wire circuit. In a case that the charging station is a three-phase charging station, the live wire connection terminal of the preset auxiliary detection circuit is connected to an input terminal of a live-wire relay of any one phase of a live wire circuit in the three-phase live wire circuit. A neutral wire connection terminal of the preset auxiliary detection circuit is connected to the neutral wire circuit.

In a second aspect, a method for detecting sticking of a relay is provided according to the present application, which is applied to a charging station. The charging station includes a live wire circuit, a neutral wire circuit, a ground wire circuit, a detection voltage acquisition module and a first sticking detection module. The neutral wire circuit is in short circuit connection with the live wire circuit through a preset auxiliary detection circuit. The preset auxiliary detection circuit includes a preset auxiliary resistor, and a resistance of the preset auxiliary resistor is greater than or equal to a preset threshold. The method includes:
acquiring a sticking detection value based on the preset auxiliary detection circuit; and
performing relay sticking detection on a neutral-wire relay based on a charging state of the charging station and the sticking detection value.

In a third aspect, an electronic apparatus is provided according to the present application. The apparatus includes a processor, a memory, and a system bus. The processor and the memory are connected to each other through the system bus. The memory is configured to store one or more programs, the one or more programs include instructions, and the instructions, when executed by the processor, cause the processor to perform the method for detecting sticking of a relay described above.

In a fourth aspect, a computer-readable storage medium, which stores a computer program, is provided according to the present application. The program, when executed by a processor, performs the method for detecting sticking of a relay described above.

Compared to conventional technologies, the present application has the following advantageous effects. A system and a method for detecting sticking of a relay, an electronic apparatus, and a medium are provided according to the present application, which are applied to a charging station. The system includes a live wire circuit, a neutral wire circuit, a ground wire circuit, a detection voltage acquisition module and a first sticking detection module. The neutral wire circuit is in short circuit connection with the live wire circuit through a preset auxiliary detection circuit. The preset auxiliary detection circuit includes a preset auxiliary resistor, and a resistance of the preset auxiliary resistor is greater than or equal to a preset threshold. The detection voltage acquisition module is configured to acquire a sticking detection value based on the preset auxiliary detection circuit. The first sticking detection module is configured to perform relay sticking detection on a neutral-wire relay based on a charging state of the charging station and the sticking detection value. In the system for detecting sticking of a relay according to the present application, the preset auxiliary detection circuit is provided between the neutral wire circuit and the live wire circuit of the charging station, a short circuit connection can be formed between the neutral wire circuit and the live wire circuit by the preset auxiliary detection circuit, and the resistance of the preset auxiliary resistor is greater than or equal to the preset threshold. The accuracy of the current between the neutral wire circuit and the live wire circuit in the charging station is improved through the high voltage and the high resistance. When the relay sticking detection is performed based on the voltage between the neutral wire circuit and the ground wire circuit, the relay sticking detection of the neutral wire circuit can be performed based on the calculated sticking detection value with high accuracy. Since the charging station is in different circuit conduction conditions under different charging states, the relay sticking detection for the neutral wire circuit is performed based on an actual charging state of the charging station and the sticking detection value. Therefore, the accuracy of the relay sticking detection of the neutral wire circuit is improved.

### BRIEF DESCRIPTION OF THE DRAWINGS

For clearer illustration of the technical solutions in the embodiments of the present application or in the conventional technology, the drawings used in the description of the embodiments of the present application or the conventional technology are briefly introduced below. Apparently, the drawings in the following descriptions are only some embodiments of the present application, and other drawings can be obtained by those skilled in the art based on these drawings without any creative effort.
Figure 1 is a schematic structural diagram of a system for detecting sticking of a relay according to an embodiment of the present application;
Figure 2 is a schematic structural diagram of a system for detecting sticking of a relay in a three-phase circuit according to an embodiment of the present application;
Figure 3 is a schematic flow chart of a method for detecting sticking of a relay according to an embodiment of the present application;
Figure 4 is a schematic structural diagram of an electronic apparatus for detecting sticking of a relay according to an embodiment of the present application; and
Figure 5 is a schematic structural diagram of a system for detecting sticking of a relay according to another embodiment of the present application.

### DETAILED DESCRIPTION

As described above, in a conventional solution for detecting sticking of a relay, whether a relay in a circuit is stuck is generally determined based on a feedback contact signal of the relay. Not all relays can be provided with a feedback contact. A neutral wire circuit in a charging station is configured to provide a convergence path for the circuit, which is mainly used to form a closed circuit, rather than as a transmission path for a control signal. Generally, a feedback contact cannot be set for a relay in the neutral wire circuit of the charging station, and it is impossible to determine whether the relay in the neutral wire circuit is stuck based on a feedback contact signal. In the conventional technology, relay sticking detection for the neutral wire circuit is generally performed based on a voltage to ground between a neutral wire and a ground wire. The voltage to ground of the neutral wire is generally very small and close to 0V, which may result in inaccurate sticking detection of the relay in the neutral wire circuit, so the accuracy of the sticking detection of the relay in the neutral wire circuit is low.

How to solve the problem, in the conventional technology, of low accuracy of sticking detection of a relay in a neutral wire circuit of a charging station is an urgent technical problem to be solved by those skilled in the art.

To solve the above problem, a system and a method for detecting sticking of a relay, an electronic apparatus, and a medium are provided according to the present application, which are applied to a charging station. The system includes a live wire circuit, a neutral wire circuit, a ground wire circuit, a detection voltage acquisition module and a first sticking detection module. The neutral wire circuit is in short circuit connection with the live wire circuit through a preset auxiliary detection circuit. The preset auxiliary detection circuit includes a preset auxiliary resistor, and a resistance of the preset auxiliary resistor is greater than or equal to a preset threshold. The detection voltage acquisition module is configured to acquire a sticking detection value based on the preset auxiliary detection circuit. The first sticking detection module is configured to perform relay sticking detection on a neutral-wire relay based on a charging state of the charging station and the sticking detection value. In the system for detecting sticking of a relay according to the present application, the preset auxiliary detection circuit is provided between the neutral wire circuit and the live wire circuit of the charging station. With the preset auxiliary detection circuit, a short circuit connection can be formed between the neutral wire circuit and the live wire circuit. The resistance of the preset auxiliary resistor is greater than or equal to the preset threshold. With a high voltage and the high resistance between the neutral wire circuit and the live wire circuit, the accuracy of a current between the neutral wire circuit and the live wire circuit in the charging station is improved. Therefore, in a case that the relay sticking detection is performed based on the voltage between the neutral wire circuit and the ground wire circuit, the relay sticking detection for the neutral wire circuit can be performed based on the calculated sticking detection value which has high calculation accuracy. Since the charging station has different circuit conduction conditions in different charging states, the relay sticking detection of the neutral wire circuit is performed based on an actual charging state of the charging station and the sticking detection value. Thus, the accuracy of the relay sticking detection of the neutral wire circuit is improved.

In order to enable those skilled in the art to understand the solutions of the present application, the technical solutions of the embodiments of the present application are described clearly and completely below in conjunction with the drawings of the embodiments of the present application. Apparently, the embodiments described below are only some of the embodiments of the present application, rather than all of the embodiments of the present application. Any other embodiments obtained by those skilled in the art based on the embodiments in the present application without creative efforts shall fall within the protection scope of the present application.

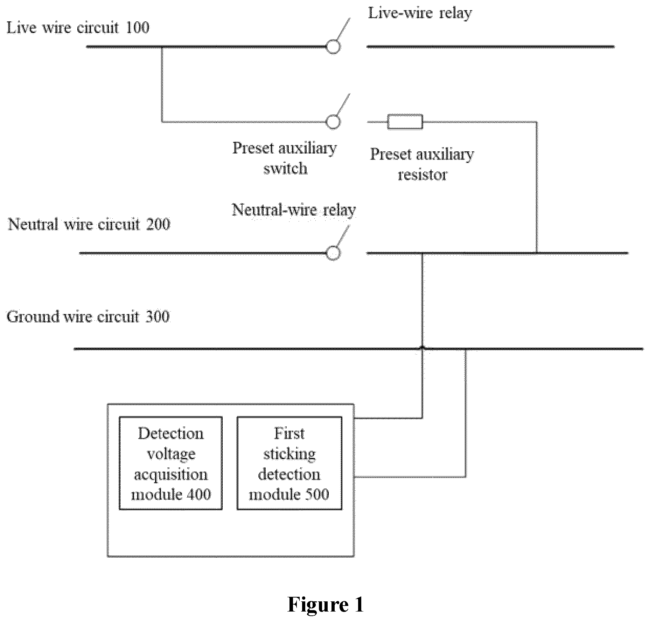

Reference is made to Figure 1, which is a schematic structural diagram of a system for detecting sticking of a relay according to an embodiment of the present application. The system according to the present application is applied to a charging station. In the embodiment, the system includes a live wire circuit 100, a neutral wire circuit 200, a ground wire circuit 300, a detection voltage acquisition module 400, and a first sticking detection module 500.

The detection voltage acquisition module 400 is configured to acquire a sticking detection value based on a preset auxiliary detection circuit.

In the conventional technology, regarding relay sticking detection in a neutral wire circuit, whether a relay in the neutral circuit is stuck is generally detected based on a voltage to ground between a neutral wire and a ground wire. Normally, a current flows only in the neutral wire and a corresponding wire, and does not flow to a ground wire. In a case that the relay in the neutral wire is stuck, a voltage may be generated between the neutral wire and the ground wire. Hence, the relay sticking detection of the neutral wire circuit can be performed based on the voltage to ground between the neutral wire and the ground wire. In the conventional technology, even if a neutral-wire relay is stuck, the voltage between the neutral wire and the ground wire is very small and close to zero. Therefore, the accuracy of relay sticking detection of the neutral wire circuit in the above manner is low.

In order to improve the accuracy of relay sticking detection in the neutral wire circuit, the present application is intended to improve the accuracy of relay sticking detection through the preset auxiliary detection circuit. Details thereof can be further understood in conjunction with Figure 1.

As shown in the figures, the neutral wire circuit is in short circuit connection with the live wire circuit through the preset auxiliary detection circuit. The preset auxiliary detection circuit includes a preset auxiliary switch and a preset auxiliary resistor. One end of the preset auxiliary switch is connected to an input terminal of a live-wire relay, and the other end of the preset auxiliary switch is connected to one end of the preset auxiliary resistor. The other end of the preset auxiliary resistor is connected to the neutral wire circuit. The resistance value of the preset auxiliary resistor is greater than or equal to a preset threshold. Thus, the accuracy of a current between the neutral wire circuit and the live wire circuit of the charging station is guaranteed through the high resistance value. A specific value of the preset threshold of the preset auxiliary resistor may be determined based on priori information of a voltage and a current between the neutral wire and the live wire in a historical time, so that the accuracy of the current between the neutral wire circuit and the live wire circuit can be ensured. The manner of determining the preset threshold of the preset auxiliary resistor is not specifically limited in the embodiment.

In an actual application scenario, the resistance value of the preset auxiliary resistor is usually set relatively large. The large resistance value can effectively limit the current flowing through a short-circuit point when a short circuit is formed between the neutral wire and the live wire. The larger the resistance can achieve a greater limitation on the current in the circuit, and hence, the accuracy of the current between the neutral wire circuit and the live wire circuit in the charging station is improved. In an actual application scenario, the accuracy of the current between the neutral wire circuit and the live wire circuit may be improved by limiting the current to a milliampere level. The manner of improving the accuracy of the current between the neutral wire circuit and the live wire circuit is not specifically limited in the embodiment. As the accuracy of the current between the neutral wire circuit and the live wire circuit is improved, the value of the current is more precise. Therefore, a voltage parameter between the neutral wire circuit and the ground wire circuit, which is calculated based on the current between the neutral wire circuit and the live wire circuit, is accurate. In this way, in the case that the relay sticking detection of the neutral wire circuit is performed based on the voltage parameter between the neutral wire circuit and the ground wire circuit, the accuracy of the relay sticking detection of the neutral wire circuit is significantly improved.

In the preset auxiliary detection circuit, in order to improve the accuracy of the current between the neutral wire circuit and the live wire circuit by using the preset auxiliary resistor, the resistance value of the preset auxiliary resistor may be predetermined based on the voltage between the neutral wire circuit and the live wire circuit in the charging station. In an embodiment, a preset resistance threshold may be set, and the resistance of the preset auxiliary resistor may be limited within a range not lower than the preset resistance threshold, so that the resistance of the preset auxiliary resistor is maintained within a numerical interval with large values. In a case that the resistance of the preset auxiliary resistor falls within the numerical interval, the current flowing through the preset auxiliary resistor is limited to a milliampere level or a more accurate unit of current, thereby ensuring a fine control of the current by the preset auxiliary detection circuit.

When the relay sticking detection is performed in the neutral wire circuit, a sticking detection value for the neutral wire circuit is first obtained through the detection voltage acquisition module 400. With the preset auxiliary detection circuit, the accuracy of the current flowing to the neutral wire circuit is improved. For example, the current is a milliampere-level current, the sticking detection value between the neutral wire circuit and the ground wire circuit can be calculated based on a value of the milliampere-level current in the neutral wire circuit. In an embodiment, the sticking detection value may be a root-mean-square value of the voltage between the neutral wire circuit and the ground wire circuit, or may be other reference parameters derived based on the voltage. The specific form of the sticking detection value is not specifically limited in the embodiment.

In this embodiment, the sticking detection value is the root-mean-square value of the voltage. Compared with the conventional solution of performing relay sticking detection based on a voltage value between the neutral wire and the ground wire, in a power system, a root-mean-square value of the voltage determines energy transmission and power consumption, and the root-mean-square value of the voltage can better represent average energy of a voltage signal in a complete cycle than the voltage. The sticking detection for the relay in the neutral wire circuit is performed based on the root-mean-square value of the voltage between the neutral wire circuit and the ground wire circuit, so that a sticking state of the relay in the circuit can be determined through a more refined value.

The first sticking detection module 500 is configured to perform relay sticking detection on a neutral-wire relay based on a charging state of the charging station and the sticking detection value.

In an actual application scenario, under different charging states, the relay in the neutral wire circuit and the relay in the live wire circuit are in different states, that is, in a closed state or an opened state. The closing or opening of the relays in the neutral wire circuit and the live wire circuit affects the magnitude of the current between the neutral wire circuit and the live wire circuit, and thus the sticking detection value between the neutral wire circuit and the ground wire circuit is changed accordingly. Therefore, in the case that the relay sticking detection of the neutral-wire relay is performed based on the sticking detection value, the sticking detection of the neutral-wire relay is performed by combining an actual charging state of the charging station and the sticking detection value, and a specific sticking detection process is implemented through the following two steps.

In step 1, a first preset detection value interval is determined based on the charging state of the charging station; and

In step 2, it is determined that the neutral wire circuit has a relay sticking fault in a case that the sticking detection value falls within the first preset detection value interval.

As can be seen from the above, in different charging states of the charging station, the relays in the neutral wire circuit and the live wire circuit have different on-off states. Therefore, it is expected to perform relay sticking fault detection in conjunction with the actual charging state of the charging station. For example, in a case that the charging station is in a charging state, the relay of the live wire circuit and the relay of the live wire circuit are both in a closed state. In this way, in an application scenario of the present application, the first preset detection value interval is from 220Vrms to 230Vrms. It is determined that the neutral-wire relay has a sticking fault in a case that the sticking detection value falls within the first preset detection value interval.

Further, for example, in a case that the charging station is not in the charging state, the relays of the live wire circuit and the neutral wire circuit are in the disconnected state, and correspondingly, the first preset detection value interval is from 0Vrms to 30Vrms. It is determined that the neutral wire circuit has a relay sticking fault in a case that the sticking detection value falls within this interval.

It can be seen that, different charging states of the charging station can lead to different states of the relays in the neutral wire circuit and the live wire circuit, so that when the first sticking detection module performs relay sticking detection on the neutral wire circuit, the first sticking detection module may synchronize the charging state of the charging station and the actually obtained sticking detection value to perform the relay sticking detection of the neutral wire circuit. In this way, the accuracy of relay sticking detection of the neutral wire circuit can be improved.

In an optional embodiment, the system for detecting sticking of a relay further includes a circuit adjustment module. The circuit adjustment module is specifically configured to perform the following two steps.

In step 1, a live wire connection terminal of the preset auxiliary detection circuit is connected to an output terminal of the live-wire relay, in response to a live-wire-relay detection instruction. The live-wire-relay detection instruction is for determining whether the live-wire relay is abnormal; and

In step 2, it is determined that the live-wire relay is normal in a case that the preset auxiliary detection circuit forms a short circuit connection between the neutral wire circuit and the live wire circuit.

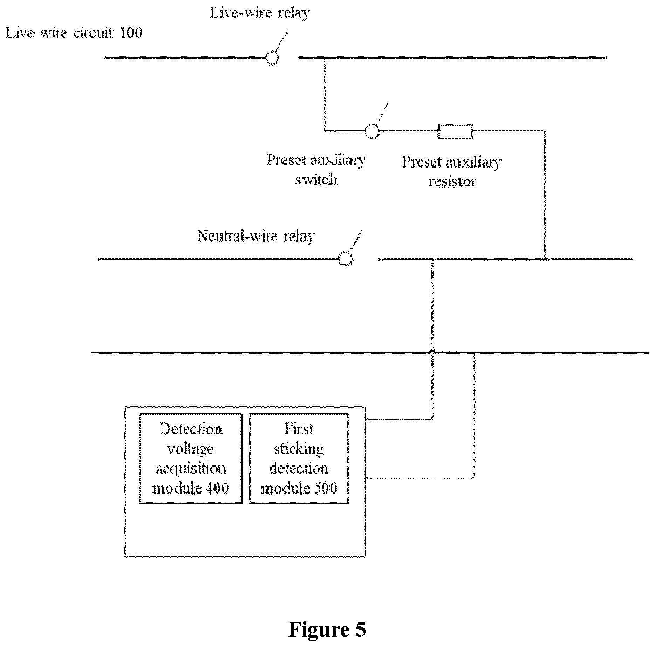

Reference is made to Figure 5, which is a schematic structural diagram of a system for detecting sticking of a relay according to another embodiment of the present application. The adjustment of the preset auxiliary detection circuit through the circuit adjustment module can be further described with reference to Figure 1 and Figure 5.

As shown in Figure 1, in the solution of the sticking detection of the neutral-wire relay according to the present application, the accuracy of the current in the neutral wire circuit is improved by the short circuit connection between the live wire circuit and the neutral wire circuit, so as to implement the subsequent sticking detection of the neutral-wire relay. Therefore, the live wire connection terminal of the preset auxiliary detection circuit in the live wire circuit is connected to the input terminal of the live-wire relay, so that the sticking detection of the neutral-wire relay can be performed at any time.

In an actual application scenario, the sticking detection of the neutral-wire relay and the abnormality detection of the live-wire relay are performed based on the actual application situation. Since the stability of the live-wire relay is crucial to the safety of the circuit, sometimes it is expected to perform the sticking detection of the neutral-wire relay after it is determined that the live-wire relay is normal. On the basis of the circuit for detecting sticking of the neutral-wire relay as shown in Figure 1, the abnormal detection of the live-wire relay requires a corresponding circuit for detecting sticking of the live-wire relay, which is redundant.

In order to solve this problem, the system for detecting sticking of a relay according to the present application is further provided with a circuit adjustment module. In response to an external instruction for abnormality detection of the live-wire relay, the circuit adjustment module connects the preset auxiliary detection circuit to the output terminal of the live-wire relay. In a case that the live-wire relay is abnormal, the live wire circuit is not conducted to the preset auxiliary detection circuit. In a case that the preset auxiliary detection circuit normally forms a short circuit connection between the neutral wire circuit and the live wire circuit, it is determined that the live-wire relay is normal, thereby realizing the abnormality detection of the live-wire relay without establishing any additional detection circuit. The abnormality detection efficiency of the relays in the live wire circuit and the neutral wire circuit in the overall circuit system of the charging station is improved.

In an optional embodiment, the system for detecting sticking of a relay according to the present application further includes a voltage fluctuation adjustment module and a power supply grid. The power supply grid is connected to the charging station. The voltage fluctuation adjustment module is specifically configured to perform the following two steps.

In step 1, a voltage fluctuation coefficient of the power supply grid within a preset time interval is determined based on voltage statistical data of the power supply grid within the preset time interval; and

In step 2, the first preset detection value interval is adjusted based on the voltage fluctuation coefficient, to obtain a second preset detection value interval.

In the conventional technology, an automobile charging station is generally connected to the power supply grid. Due to various environmental factors such as weather, the power supply grid may have a significant voltage fluctuation in some specific time periods. Such fluctuations may simultaneously affect a voltage between the neutral wire and the live wire, and accordingly, a voltage between the neutral wire and the ground wire may be affected, thereby affecting the accuracy of the relay sticking detection of the neutral wire circuit.

In order to cope with the voltage fluctuation in the power supply grid, the system for detecting sticking of a relay according to the present application further includes the voltage fluctuation adjustment module. The voltage fluctuation adjustment module is configured to determine the voltage fluctuation coefficient of the power supply grid within the preset time interval based on the voltage statistical data of the power supply grid within the preset time interval. The preset time interval may be determined based on a specific fluctuation time period of the power supply grid, or may be pre-determined based on changes of weather. In the process of determining the voltage fluctuation coefficient based on the voltage statistical data of the power supply grid, statistical analysis may be performed on the obtained voltage statistical data to obtain statistical indicators such as a mean value or a standard deviation of voltages of the power supply grid within the preset time interval. The voltage fluctuation coefficient of the power supply grid is determined through a standard formula for calculating the voltage fluctuation coefficient. The manner of determining the preset time interval and the manner of determining the voltage fluctuation coefficient are not specifically limited in the embodiments of the present application.

After the voltage fluctuation coefficient is obtained, the voltage fluctuation coefficient is multiplied by the first preset detection value interval to adjust the first preset detection value interval, so as to obtain the second preset detection value interval.

In an optional embodiment, the system for detecting sticking of a relay according to the present application further includes a second sticking detection module. The second sticking detection module is specifically configured to perform the following two steps.

In step 1, relay sticking detection is performed on the live wire circuit to obtain a sticking detection result of the live-wire relay; and

In step 2, the preset auxiliary switch is controlled to be in an off state, in a case that the sticking detection result of the live-wire relay indicates that the live-wire relay is stuck.

As can be seen from the above, the reason why the sticking detection of the neutral-wire relay needs to be performed in combination with the charging state of the charging station is that: different charging states of the charging station may cause the relays of the neutral wire circuit and the live wire circuit to be in different states, which affect the sticking detection. It is necessary to ensure that the relay of the live wire circuit has no sticking fault before performing relay sticking detection of the neutral wire circuit.

According to the present application, the system for detecting sticking of a relay further includes the second sticking detection module. The second sticking detection module is configured to, before the first sticking detection module performs relay sticking detection on the neutral wire circuit, determine whether the live-wire relay is normal and obtain the sticking detection result of the live-wire relay. In a case that the sticking detection result of the live-wire relay indicates that the live-wire relay has a relay sticking fault, the first sticking detection module is not allowed to perform the relay sticking detection of the neutral wire circuit. In this case, the preset auxiliary switch in the preset auxiliary circuit is controlled to be in an open state to prohibit the relay sticking detection of the neutral wire circuit, thereby ensuring the accuracy of the relay sticking detection of the neutral wire circuit.

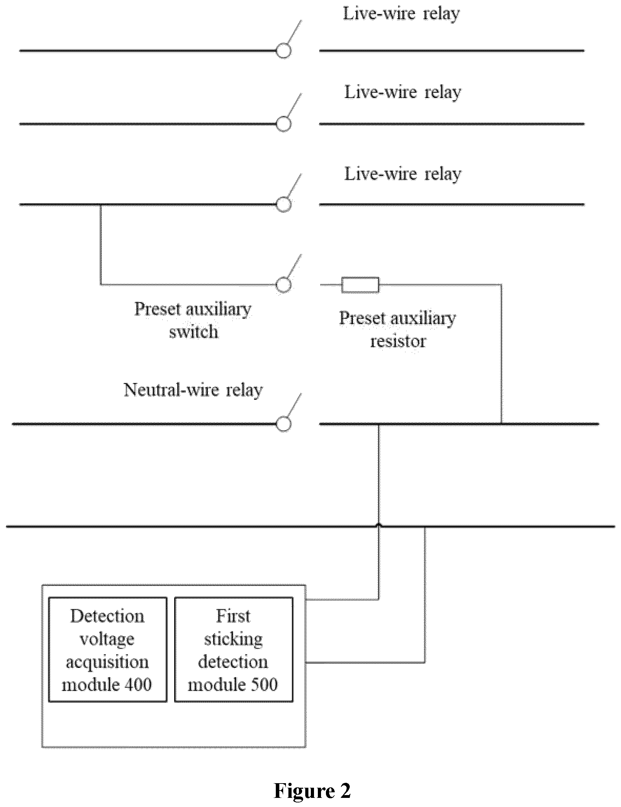

In addition, the system for detecting sticking of a relay according to the present application may be applied to a charging station system with a three-phase circuit, which may be further described with reference to a schematic structural diagram of a system for detecting sticking of a relay in a three-phase circuit shown in Figure 2.

In a case that the system for detecting sticking of a relay is applied to a three-phase circuit, any one phase of a live wire circuit is selected to form a short circuit connection between the live wire circuit and the neutral wire circuit through the preset auxiliary detection circuit, thereby determining whether there is relay sticking in the neutral wire circuit. The principle involved is the same as that of the system for detecting sticking of a relay in a single-phase circuit, which is not described in detail in the present application. Similarly, in the three-phase circuit, the circuit adjustment module involved can flexibly adjust a specific position of the preset auxiliary detection circuit when an abnormality detection of the live-wire relay is required to be performed, which is not described in detail in the embodiment.

The system for detecting sticking of a relay is provided according to the embodiment, which is applied to a charging station. The system includes the live wire circuit, the neutral wire circuit, the ground wire circuit, the detection voltage acquisition module and the first sticking detection module. The neutral wire circuit is in short circuit connection with the live wire circuit through the preset auxiliary detection circuit. The preset auxiliary detection circuit includes the preset auxiliary resistor, and the resistance of the preset auxiliary resistor is not less than the preset threshold. The detection voltage acquisition module is configured to acquire the sticking detection value based on the preset auxiliary detection circuit. The first sticking detection module is configured to perform relay sticking detection on the neutral-wire relay based on the charging state of the charging station and the sticking detection value. In the system for detecting sticking of a relay according to the present application, the preset auxiliary detection circuit is provided between the neutral wire circuit and the live wire circuit of the charging station. A short-circuit connection can be formed between the neutral wire circuit and the live wire circuit through the preset auxiliary detection circuit, and the resistance of the preset auxiliary resistor is greater than or equal to the preset threshold. With the high voltage and the high resistance, the accuracy of the current between the neutral wire circuit and the live wire circuit in the charging station is improved. In the case that the relay sticking detection is performed based on the voltage between the neutral wire circuit and the ground wire circuit, the relay sticking detection of the neutral wire circuit can be performed based on the calculated sticking detection value with high accuracy. Since the charging station is in different circuit conduction conditions under different charging states, the relay sticking detection of the neutral wire circuit is performed based on the actual charging state of the charging station and the sticking detection value. The accuracy of the relay sticking detection of the neutral wire circuit is improved.

A method for detecting sticking of a relay according to an embodiment of the present application is illustrated below. The method for detecting sticking of a relay and the system for detecting sticking of a relay described above may be referred to each other.

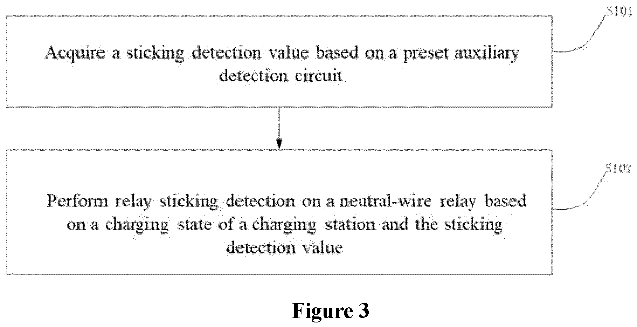

Reference is made to Figure 3, which is a schematic flow chart of a method for detecting sticking of a relay according to an embodiment of the present application. The method for detecting sticking of a relay according to the present application is applied to a charging station. The charging station includes a live wire circuit, a neutral wire circuit, a ground wire circuit, a detection voltage acquisition module and a first sticking detection module. The neutral wire circuit is in short circuit connection with the live wire circuit through a preset auxiliary detection circuit. The preset auxiliary detection circuit includes a preset auxiliary resistor, and a resistance of the preset auxiliary resistor is greater than or equal to a preset threshold. The method includes the following steps S101 to S102.

In S101, a sticking detection value is acquired based on the preset auxiliary detection circuit.

In S102, relay sticking detection of a neutral-wire relay is performed based on a charging state of the charging station and the sticking detection value.

In an embodiment, the relay sticking detection of the neutral-wire relay is performed based on the charging state of the charging station and the sticking detection value, which specifically includes the following steps:
determining a first preset detection value interval based on the charging state of the charging station; and
determining that the neutral wire circuit has a relay sticking fault in a case that the sticking detection value falls within the first preset detection value interval.

In an embodiment, the live wire circuit includes a live-wire relay. A live wire connection terminal of the preset auxiliary detection circuit is connected to an input terminal of the live-wire relay. The live wire connection terminal of the preset auxiliary detection circuit is used to indicate a connecting end point of the preset auxiliary detection circuit on the live wire circuit. After step S102, the method further includes the following steps:
connecting the live wire connection terminal of the preset auxiliary detection circuit to an output terminal of the live-wire relay, in response to a live-wire-relay detection instruction; where the live-wire-relay detection instruction is configured for determining whether the live-wire relay has a relay abnormality; and
determining that the live-wire relay has no abnormality in a case that the preset auxiliary detection circuit forms a short circuit connection between the neutral wire circuit and the live wire circuit.

In an embodiment, the preset auxiliary detection circuit includes a preset auxiliary switch. The preset auxiliary switch has an end connected to the live wire circuit, and the other end connected to an end of the preset auxiliary resistor. The other end of the preset auxiliary resistor is connected to the neutral wire circuit. The preset auxiliary switch is in a closed state when the first sticking detection module performed sticking detection on the neutral-wire relay.

In an embodiment, the charging station is connected to a power supply grid. After determining the first preset detection value interval based on the charging state of the charging station, the method further includes:
determining a voltage fluctuation coefficient of the power supply grid within a preset time interval based on voltage statistical data of the power supply grid within the preset time interval; and
adjusting the first preset detection value interval based on the voltage fluctuation coefficient, to obtain a second preset detection value interval.

In an embodiment, before acquiring the sticking detection value based on the preset auxiliary detection circuit, the method further includes:
performing relay sticking detection on the live wire circuit to obtain a sticking detection result of the live-wire relay; and
controlling the preset auxiliary switch to be in an off state, in a case that the sticking detection result of the live-wire relay indicates that the live-wire relay is stuck.

In an embodiment, the charging station includes a three-phase charging station.

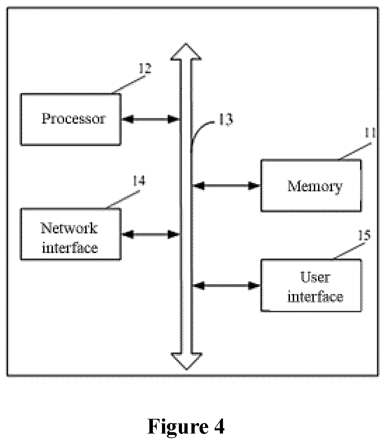

Reference is made to Figure 4, which is a schematic structural diagram of an electronic apparatus for detecting sticking of a relay according to an embodiment of the present application. The electronic apparatus includes a memory 11 and a processor 12. The memory 11 is configured to store a computer program. The processor 12 is configured to, when executing the computer program, implement the steps of the method for detecting sticking of a relay described above.

In the embodiment, the apparatus may be a vehicle-mounted computer, a PC (personal computer), or may be a terminal device such as a smart phone, a tablet computer, a palmtop computer, or a portable computer.

The apparatus may include the memory 11, the processor 12 and a bus 13.

The memory 11 at least includes one type of readable storage medium, the readable storage medium includes a flash memory, a hard disk, a multimedia card, a card-type memory (such as a SD or DX memory), a magnetic memory, a magnetic disk, an optical disk, and the like. In some embodiments, the memory 11 may be an internal storage unit of the apparatus, such as a hard disk of the apparatus. In other embodiments, the memory 11 may be an external storage device of the apparatus, such as a plug-in hard disk, a smart media card (SMC), a secure digital (SD) card, or a flash card, equipped for the apparatus. Further, the memory 11 may include both an internal storage unit and an external storage device of the apparatus. The memory 11 may be configured to store application software installed on the apparatus and various data, such as program codes for performing a fault prediction method, and may be further configured to temporarily store data that has been outputted or is to be outputted. In some embodiments, the processor 12 may be a central processing unit (CPU).

In some embodiments, the processor 12 may be a central processing unit (CPU), a controller, a microcontroller, a microprocessor or any other data processing chip, and is configured to run the program codes stored in the memory 11 or process data, such as the program codes for performing a fault prediction method.

The bus 13 may be a peripheral component interconnect (PCI) bus, an extended industry standard architecture (EISA) bus, or the like. The bus may include an address bus, a data bus, a control bus, and the like. For ease of illustration, in Figure 4, the bus is shown by only one thick line, but this does not mean that there is only one bus or one type of bus.

Further, the apparatus may further include a network interface 14. The network interface 14 may optionally include a wired interface and/or a wireless interface (such as a WI-FI interface, or a Bluetooth interface), which is usually for establishing a communication connection between the apparatus and another electronic apparatus.

In an embodiment, the apparatus may further include a user interface 15. The user interface 15 may include a display and an input unit, such as a keyboard. Optionally, the user interface 15 may further include a standard wired interface and a standard wireless interface. Optionally, in some embodiments, the display may be an LED display, a liquid crystal display, a touch-controlled liquid crystal display, an organic light-emitting diode (OLED) touch device, or the like. The display, which may appropriately be referred to as a display screen or display unit, is configured to display information processed in the apparatus and display a visualized user interface.

Figure 4 only illustrates the apparatus having components 11 to 15. Those skilled in the art can understand that the structure shown in Figure 4 does not constitute a limitation on the apparatus. The apparatus may include fewer or more components than shown in the figure, or may include a combination of some components, or may have a different arrangement of components.

It should be noted that the embodiments of the present application are described in a progressive manner. The same and similar parts of the embodiments can be referred to each other. Each of the embodiments focuses on the differences from the other embodiments. Particularly, a method, system, electronic apparatus, and medium are essentially similar to method embodiments, and are therefore described in brief, and reference may be made to the description of the method embodiments for relevant parts. The method, system, electronic apparatus, and the medium described above are only illustrative, and the units described as separate components may be or may not be physically separated. A component shown as a unit may be or may not be a physical unit, that is, the component may be located at the same position or distributed over multiple network units. Some or all of the modules may be adopted as needed to achieve the object of the solutions of the embodiments. Those skilled in the art can understand and implement the embodiments without any creative effort.

The above are only some embodiments of the present application, and the protection scope of the present application is not limited thereto. Any changes or substitutions that can be easily obtained by those skilled the art within the technical scope disclosed in the present application shall fall within the protection scope of the present application. The protection scope of the present application shall be in accordance with the protection scope of the claims.

## Claims

1. A system for detecting sticking of a relay, applied to a charging station, comprising:
a live wire circuit;
a neutral wire circuit;
a ground wire circuit;
a detection voltage acquisition module; and
a first sticking detection module; wherein
the neutral wire circuit is in short circuit connection with the live wire circuit through a preset auxiliary detection circuit;
the preset auxiliary detection circuit comprises a preset auxiliary resistor, wherein a resistance of the preset auxiliary resistor is greater than or equal to a preset threshold;
the detection voltage acquisition module is configured to acquire a sticking detection value based on the preset auxiliary detection circuit; and
the first sticking detection module is configured to perform relay sticking detection on a neutral-wire relay based on a charging state of the charging station and the sticking detection value.

2. The system according to claim 1, wherein the first sticking detection module is configured to:
determine a first preset detection value interval based on the charging state of the charging station; and
determine that the neutral wire circuit has a relay sticking fault in a case that the sticking detection value falls within the first preset detection value interval.

3. The system according to claim 1, wherein
the preset auxiliary detection circuit comprises a preset auxiliary switch;
the live wire circuit comprises a live-wire relay;
the preset auxiliary switch has an end connected to an input terminal of the live-wire relay and the other end connected to an end of the preset auxiliary resistor;
the other end of the preset auxiliary resistor is connected to the neutral wire circuit; and the preset auxiliary switch is in a closed state when the first sticking detection module performs sticking detection on the neutral-wire relay.

4. The system according to claim 3, further comprising a circuit adjustment module, wherein the circuit adjustment module is configured to:
connect a live wire connection terminal of the preset auxiliary detection circuit to an output terminal of the live-wire relay, in response to a live-wire-relay detection instruction; wherein the live-wire-relay detection instruction is for determining whether an abnormality occurs on the live-wire relay, and the live wire connection terminal of the preset auxiliary detection circuit is configured to indicate a connecting end point, on the live wire circuit, of the preset auxiliary detection circuit; and
determine that the live-wire relay has no abnormality in a case that the preset auxiliary detection circuit forms a short circuit connection between the neutral wire circuit and the live wire circuit.

5. The system according to claim 2, further comprising a voltage fluctuation adjustment module and a power supply grid, wherein the power supply grid is connected to the charging station, and the voltage fluctuation adjustment module is configured to:
determine a voltage fluctuation coefficient of the power supply grid within a preset time interval based on voltage statistical data of the power supply grid within the preset time interval; and
adjust the first preset detection value interval based on the voltage fluctuation coefficient to obtain a second preset detection value interval.

6. The system according to claim 1, further comprising a second sticking detection module, wherein the second sticking detection module is configured to:
perform relay sticking detection on the live wire circuit to obtain a sticking detection result of a live-wire relay; and
control a preset auxiliary switch to be in an open state, in a case that the sticking detection result of the live-wire relay indicates that the live-wire relay is stuck.

7. The system according to any one of claims 1 to 6, wherein the charging station comprises a three-phase charging station, and the three-phase charging station comprises a three-phase live wire circuit; in a case that the charging station is a three-phase charging station, a live wire connection terminal of the preset auxiliary detection circuit is connected to an input terminal of a live-wire relay of any one phase of a live wire circuit in the three-phase live wire circuit, and a neutral wire connection terminal of the preset auxiliary detection circuit is connected to the neutral wire circuit.

8. A method for detecting sticking of a relay, applied to a charging station, wherein the charging station comprises a live wire circuit, a neutral wire circuit, a ground wire circuit, a detection voltage acquisition module and a first sticking detection module; the neutral wire circuit is in short circuit connection with the live wire circuit through a preset auxiliary detection circuit; the preset auxiliary detection circuit comprises a preset auxiliary resistor, and a resistance of the preset auxiliary resistor is greater than or equal to a preset threshold; and the method comprises:
acquiring a sticking detection value based on the preset auxiliary detection circuit; and
performing relay sticking detection on a neutral-wire relay based on a charging state of the charging station and the sticking detection value.

9. An electronic apparatus, comprising a processor, a memory, and a system bus; wherein the processor and the memory are connected to each other through the system bus;
the memory is configured to store one or more programs; wherein the one or more programs comprise instructions, and the instructions, when executed by the processor, cause the processor to perform the method according to claim 8.

10. A computer-readable storage medium, which stores a computer program, wherein the program, when executed by a processor, performs the method according to claim 8.
